(19) Europäisches Patentamt
European Patent Office
Office européen des brevets

(11) **EP 2 652 792 B1**

(12) **FASCICULE DE BREVET EUROPEEN**

(45) Date de publication et mention
de la délivrance du brevet:
**12.09.2018 Bulletin 2018/37**

(21) Numéro de dépôt: **11815441.8**

(22) Date de dépôt: **13.12.2011**

(51) Int Cl.:
*H01L 31/02* (2006.01)          *H01L 31/107* (2006.01)
*G01J 3/00* (2006.01)           *H01L 31/0352* (2006.01)
*H01L 27/146* (2006.01)         *H04N 5/30* (2006.01)

(86) Numéro de dépôt international:
**PCT/EP2011/072618**

(87) Numéro de publication internationale:
**WO 2012/080256 (21.06.2012 Gazette 2012/25)**

(54) **PHOTODETECTEUR AYANT UNE SENSIBILITE SPECTRALE**

FOTODETEKTOR MIT SPEKTRALER EMPFINDLICHKEIT

PHOTODETECTOR HAVING SPECTRAL SENSITIVITY

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **14.12.2010 FR 1004866**

(43) Date de publication de la demande:
**23.10.2013 Bulletin 2013/43**

(73) Titulaire: **Université d'Aix-Marseille
13284 Marseille Cedex 07 (FR)**

(72) Inventeur: **GACH, Jean-Luc
F-13790 Peynier (FR)**

(74) Mandataire: **de Roquemaurel, Bruno et al
OMNIPAT
24 Place des Martyrs de la Résistance
13100 Aix en Provence (FR)**

(56) Documents cités:
**JP-A- 2008 241 578     US-A1- 2006 131 480**

- **KIRN TH ET AL: "Wavelength dependence of avalanche photodiode (APD) parameters", NUCLEAR INSTRUMENTS & METHODS IN PHYSICS RESEARCH. SECTION A: ACCELERATORS, SPECTROMETERS, DETECTORS, AND ASSOCIATED EQUIPMENT, ELSEVIER BV * NORTH-HOLLAND, NETHERLANDS, vol. 387, no. 1, 1 mars 1997 (1997-03-01), pages 202-204, XP004058947, ISSN: 0168-9002, DOI: 10.1016/S0168-9002(96)00990-4**

**Description**

La présente invention concerne le domaine des photodétecteurs et en particulier ceux utilisés pour la capture d'image dans différents domaines de longueurs d'onde. Des photodétecteurs peuvent ainsi être disposés selon une configuration matricielle pour réaliser un imageur.

La présente invention s'applique notamment à l'imagerie dans le domaine de l'infrarouge, et en particulier à la vision nocturne, à l'observation de la terre et l'astronomie.

Les photodétecteurs actuels ne permettent généralement pas de fournir une information sur la longueur d'onde des photons qu'ils détectent. Pour obtenir une telle information, il est toutefois connu d'associer au photodétecteur un filtre limitant la sensibilité du photodétecteur à une plage de longueurs d'onde plus réduite. Il est ainsi connu d'utiliser dans les imageurs soit un filtre global couvrant tous les pixels de l'imageur et limitant la sensibilité de tous les pixels à une même plage de longueurs d'onde, soit un filtre ayant une distribution de couleurs permettant de générer des images en couleurs. Ainsi les imageurs couleurs grand public de type CCD ou CMOS sont couramment associés à une matrice de filtres de type Bayer associant à chaque pixel de l'imageur un filtre rouge, vert ou bleu.

Le document US 2006/0131480 décrit un procédé de détection spectral utilisant une photodiode à avalanche en mode Geiger.

Le document US 5 965 875 décrit un photodétecteur exploitant les capacités intrinsèques des matériaux semi-conducteurs à se laisser pénétrer par les photons à une profondeur dépendant de la longueur d'onde du photon, où une paire d'électron-trou est générée. A cet effet, le photodétecteur décrit dans ce document comprend une structure multicouche, dont chaque couche a subi un traitement de dopage différent et est associée à un circuit de détection respectif. Chaque circuit de détection fournit donc un signal représentatif de la quantité de photons reçus par le photodétecteur dans une certaine plage de longueur d'onde.

Ces photodétecteurs présentent l'inconvénient de ne pas déterminer la longueur d'onde d'un photon incident, mais de fonctionner par réjection à l'aide de filtres ou en exploitant les propriétés intrinsèques de matériaux. Dans un imageur, les photons atteignant un photodétecteur, mais n'appartenant pas à une plage de longueurs d'onde donnée correspondant à la bande passante du filtre ou du matériau rencontré, ne sont pas utilisés pour former une image, bien qu'ils seraient détectés par un photodétecteur voisin. La sensibilité à l'éclairement d'un tel imageur se trouve donc réduite. Cette sensibilité se trouve par ailleurs également réduite par la présence de structures non transparentes (oxydes, polysilicium, métallisations) recouvrant une partie non négligeable de la surface sensible des imageurs. Par ailleurs, les imageurs mettant en oeuvre une matrice de filtres de différentes couleurs, présentent une résolution spatiale égale au nombre de pixels de l'imageur divisé par le nombre de plages de longueurs d'onde à discriminer. Il en résulte que le nombre de plages de longueurs d'onde discriminées dans un imageur est généralement limité à 2 ou 3.

Il est donc souhaitable de réaliser un photodétecteur permettant à l'aide d'une structure mono pixel de détecter la longueur d'onde d'un photon incident. Il est également souhaitable de réaliser un imageur comportant un tel photodétecteur.

Un mode de réalisation se base sur l'utilisation d'une photodiode à avalanche. L'effet d'avalanche peut se produire dans un matériau semi-conducteur lorsque celui-ci est soumis à un champ électrique suffisamment intense pour accélérer les électrons libres et leur conférer une énergie suffisante permettant de libérer d'autres électrons en percutant des atomes dans une zone d'avalanche. Le nombre d'électrons libres dans le matériau peut ainsi augmenter rapidement car les nouveaux électrons libres provoquent la libération d'autres électrons dans la zone d'avalanche. La présence d'un électron libre dans un matériau semi-conducteur peut résulter de l'interaction du matériau avec un photon. La zone d'avalanche peut alors générer plusieurs dizaines voire des centaines d'électrons libres, créant ainsi un signal électrique amplifié déclenché par l'apparition d'un photon. La zone d'avalanche est localisée physiquement dans un matériau semi-conducteur à la jonction entre deux zones ayant des dopages différents. L'épaisseur de la zone d'avalanche qui peut atteindre un à plusieurs micromètres, dépend de la nature du matériau semi-conducteur et de l'intensité du champ électrique auquel il est soumis, résultant de l'application d'une tension de polarisation inverse.

Des modes de réalisation concernent un procédé de détection de photons, comprenant une étape de soumission d'une photodiode formée dans un matériau semi-conducteur, à une tension de polarisation telle qu'un phénomène d'avalanche soit déclenché dans une couche d'avalanche de la photodiode lorsqu'un photon pénètre dans la photodiode. Selon un mode de réalisation, la couche d'avalanche s'étend dans le matériau semi-conducteur d'une profondeur minimum à une profondeur maximum de manière à pouvoir être atteinte par des photons ayant une longueur d'onde comprise entre des longueurs d'onde minimum et maximum, le procédé comprenant des étapes de comparaison de l'amplitude d'un signal fourni par la photodiode à deux valeurs de seuil distinctes, et de déduction que la photodiode a reçu un photon ayant une longueur d'onde comprise entre deux longueurs d'onde de seuil comprises entre les longueurs d'onde minimum et maximum, si l'amplitude du signal est comprise entre les deux valeurs de seuil.

Selon un mode de réalisation, le procédé comprend des étapes de comptage pendant une période d'acquisition, d'un nombre d'impulsions détectées aux bornes de la photodiode, ayant une amplitude comprise entre les deux valeurs de seuil pour obtenir une valeur représentative d'un nombre de photons ayant pénétré dans la photodiode pendant la période d'acquisition, et ayant une longueur d'onde comprise entre les deux longueurs d'onde de seuil.

Selon un mode de réalisation, le procédé comprend des étapes de comptage pendant une période d'acquisition, d'un nombre d'impulsions détectées aux bornes de la photodiode, ayant une amplitude supérieure à la plus grande des deux valeur de seuil pour obtenir une valeur représentative d'un nombre de photons ayant pénétré dans la photodiode pendant la période d'acquisition, et ayant une longueur d'onde inférieure à la plus petite des deux longueurs d'onde de seuil.

Selon un mode de réalisation, la plus petite des deux valeurs de seuil correspond à une longueur d'onde extrême de photon à détecter.

Selon un mode de réalisation, le procédé comprend des étapes de comparaison de l'amplitude du signal fourni par la photodiode à plusieurs autres valeurs de seuil, de manière à délimiter avec les deux valeurs de seuil plusieurs plages de valeurs d'amplitude, et de comptage pendant une période d'acquisition de nombres d'impulsions du signal dans chacune des plages de valeurs d'amplitude.

Selon un mode de réalisation, des plages de valeurs d'amplitude d'impulsion délimitées par les valeurs de seuil sont non contiguës et/ou se chevauchent.

Selon un mode de réalisation, le procédé comprend une étape d'ajustement des valeurs de seuil pour ajuster des plages de longueurs d'onde dans lesquelles des photons sont à détecter.

Selon un mode de réalisation, le procédé comprend une étape d'ajustement de la tension de polarisation de la photodiode pour que tous les photons à détecter puissent atteindre la couche d'avalanche et sans aller au-delà.

Des modes de réalisation concernent également un dispositif de détection de photons tel que défini par l'objet de la revendication 9, comprenant une photodiode formée dans un matériau semi-conducteur, et soumise à une tension de polarisation telle qu'un phénomène d'avalanche soit déclenché dans une couche d'avalanche de la photodiode lorsqu'un photon pénètre dans la photodiode. Selon un mode de réalisation, la couche d'avalanche s'étend dans le matériau semi-conducteur d'une profondeur minimum à une profondeur maximum de manière à pouvoir être atteinte par des photons ayant une longueur d'onde comprise entre des longueurs d'onde minimum et maximum, le dispositif étant configuré pour mettre en oeuvre le procédé défini précédemment.

Selon un mode de réalisation, la photodiode comprend une couche de collection de faible dopage ou non dopée dont l'épaisseur est réduite de manière à ce que la couche d'avalanche puisse s'étendre au moins jusqu'à une profondeur atteinte par des photons ayant une longueur d'onde extrême à détecter.

Selon un mode de réalisation, la photodiode comprend une jonction pn réalisée à une certaine profondeur dans le matériau semi-conducteur, le matériau semi-conducteur et la profondeur de la jonction pn étant choisis de manière à ce que le matériau semi-conducteur puisse être traversé par des photons à détecter jusqu'à une profondeur susceptible d'être située dans la couche d'avalanche de la photodiode.

Des modes de réalisation concernent également un imageur, comprenant plusieurs dispositifs de détection tels que définis précédemment, les photodiodes des dispositifs de détection étant disposées selon une configuration matricielle.

Des exemples de réalisation de l'invention seront décrits dans ce qui suit, à titre non limitatif en relation avec les figures jointes parmi lesquelles :

la figure 1 représente schématiquement une photodiode à avalanche polarisée en inverse par une source de tension continue, pour produire un effet d'avalanche,

les figures 2A et 2B représentent des courbes de variation de la profondeur de pénétration d'un photon dans deux matériaux semi-conducteurs différents, en fonction de la longueur d'onde du photon,

les figures 3A et 3B représentent schématiquement une photodiode selon un mode de réalisation, dans laquelle des photons incidents ayant des longueurs d'onde différentes déclenchent un phénomène d'avalanche,

les figures 4A et 4B représentent une courbe de variation de l'amplitude d'une impulsion de courant générée par un photon pénétrant dans la photodiode en fonction de la profondeur de pénétration du photon dans la photodiode,

la figure 5 est un schéma électrique d'un circuit de génération d'un signal de détection à partir d'un courant électrique résultant du phénomène d'avalanche dans la photodiode, selon un mode de réalisation,

la figure 5A représente une courbe de variation de l'amplitude en tension d'une impulsion apparaissant dans le signal de sortie du circuit de la figure 5, à la suite de la pénétration d'un photon dans la photodiode, en fonction de la profondeur de pénétration du photon dans la photodiode,

la figure 5B représente une courbe de variation de la profondeur de pénétration d'un photon dans la photodiode en fonction de la longueur d'onde du photon,

la figure 6 est un schéma électrique d'un circuit de génération de signaux représentatifs de l'éclairement de la photodiode dans une plage de longueurs d'onde, selon un mode de réalisation,

les figures 7A à 7H représentent des chronogrammes de signaux apparaissant dans le circuit de la figure 6,

la figure 8 est un schéma électrique d'un circuit de génération de signaux représentatifs de l'éclairement de la photodiode dans deux plages de longueurs d'onde, selon un mode de réalisation,

la figure 9 est un schéma électrique d'un circuit de génération de signaux représentatifs de l'éclairement de la photodiode dans quatre plages de longueurs d'onde, selon un mode de réalisation.

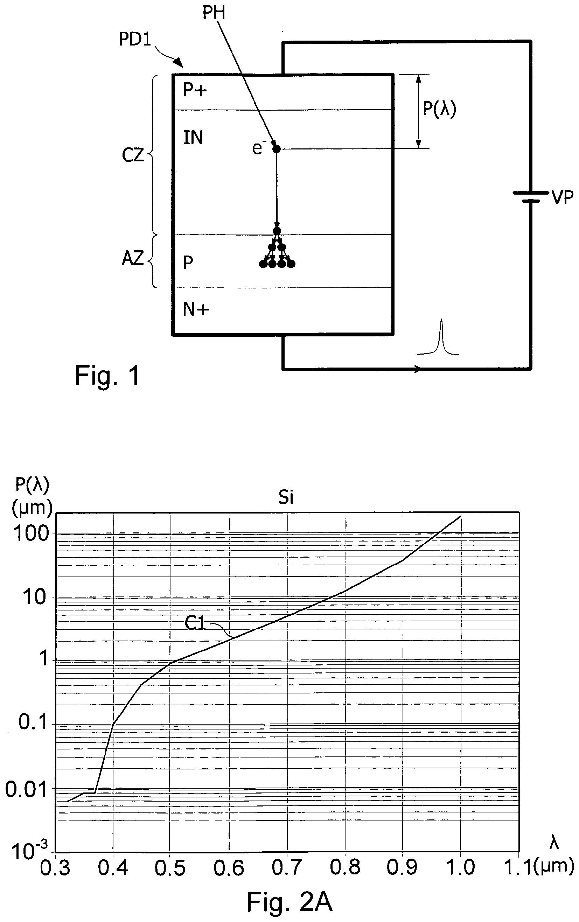

La figure 1 représente une photodiode à avalanche PD1 réalisée dans un matériau semi-conducteur comprenant plusieurs couches de dopage différentes. Ainsi, la photodiode PD1 comprend une couche profonde dopée N+, une couche dite d'"'avalanche" AZ dopée P formée au dessus de la couche profonde, une couche intermédiaire IN faiblement dopée N ou en semi-conducteur intrinsèque et une couche superficielle dopée P+. Le matériau semi-conducteur est polarisé en inverse par une source de tension continue BV produisant un champ électrique entre la couche profonde et la couche superficielle, permettant d'accélérer les électrons de la couche superficielle vers la couche profonde. La tension de polarisation est suffisante pour accélérer les électrons libres du matériau semi-conducteur et leur conférer une énergie suffisante pour libérer d'autres électrons en percutant des atomes du matériau. Le nombre d'électrons libres peut ainsi augmenter très rapidement car les nouveaux électrons libres vont à leur tour percuter des atomes et libérer d'autres électrons.

Lorsqu'un photon incident PH pénètre dans le matériau semi-conducteur à une profondeur P ($\lambda$) dans une couche dite de "collection" CZ constituée des couches superficielles et intermédiaire IN, il libère un électron e⁻. Cet électron est accéléré par le champ électrique jusqu'à la couche d'avalanche AZ. Dans la couche d'avalanche, le champ électrique est tel qu'il confère à l'électron libre une vitesse apte à libérer d'autres électrons qui libèrent à leur tour d'autres électrons. Lorsque les électrons libérés atteignent la couche profonde N+, le premier électron libéré par le photon PH s'est multiplié par un facteur G. Le phénomène d'avalanche s'apparente ainsi à un amplificateur de signal de gain égal à G. Les électrons libérés sont évacués vers la source de tension de polarisation BV et génèrent en se déplaçant une impulsion de courant appelée "courant photoélectrique".

L'épaisseur de la couche d'avalanche AZ dépend du matériau choisi, de la profondeur à laquelle est formée une jonction pn dans le matériau semi-conducteur et de la tension de polarisation en inverse de la photodiode. Cette épaisseur peut ainsi atteindre plusieurs micromètres avec une tension de polarisation en inverse élevée. La tension de polarisation ne doit toutefois pas excéder une tension de claquage de la photodiode au delà de laquelle la photodiode peut subir une altération irréversible. La tension de claquage d'une diode dépend également de la nature du matériau semi-conducteur dans lequel la diode est réalisée.

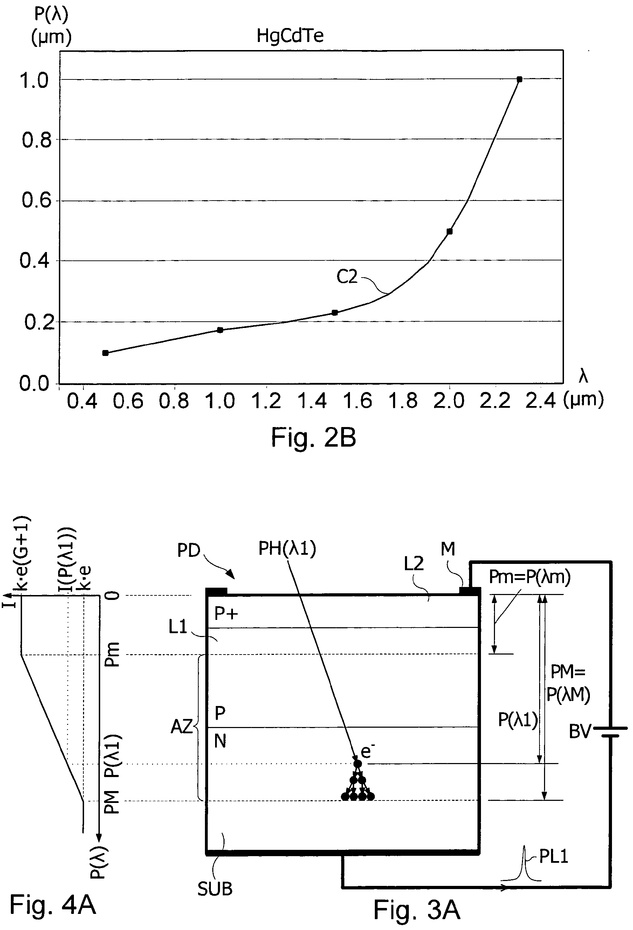

Un photon peut pénétrer dans un matériau semi-conducteur plus ou moins profondément selon sa longueur d'onde et la nature du matériau, avant d'interagir avec ce dernier en créant une paire d'électron-trou. Les figures 2A, 2B représentent des courbes C1, C2 de variation de la profondeur de pénétration d'un photon dans un matériau semi-conducteur en fonction de la longueur d'onde du photon. Le matériau semi-conducteur est du silicium sur la figure 2A, et du tellurure de cadmium et de mercure ($Hg_{1-x}Cd_xTe$ avec x = 0,45) sur la figure 2B. Les courbes C1, C2 montrent en particulier qu'à des valeurs de longueur d'onde supérieures à 0,37 $\mu m$ pour le silicium et supérieures à environ 2 $\mu m$ pour le $Hg_{0,55}Cd_{0,45}Te$, la profondeur de pénétration d'un photon augmente rapidement en fonction de la longueur d'onde.

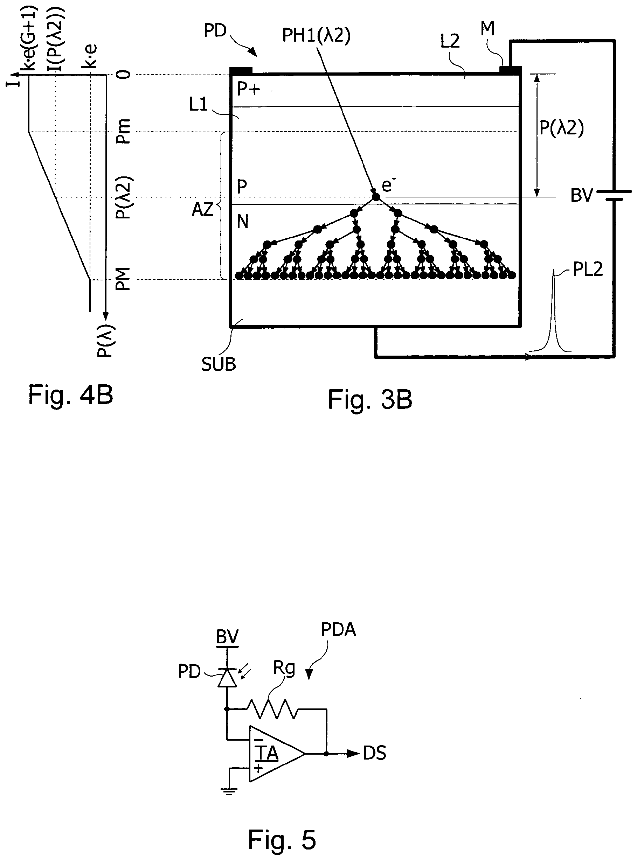

Les figures 3A et 3B représentent une photodiode PD selon un mode de réalisation. Par rapport à la photodiode PD1 représentée sur la figure 1, la photodiode PD ne comprend pas de couche de collection ou bien cette couche présente une épaisseur réduite à une valeur minimum. Dans l'exemple des figures 3A, 3B, la photodiode est formée dans un substrat SUB de type N et comprend une couche L1 dopée P sur laquelle est formée une couche L2 dopée P+. La couche L2 permet de raccorder la photodiode à une métallisation de connexion M (par exemple entourant une face sensible, réceptrice des photons, de la photodiode) formant la cathode de la photodiode. L'anode de la photodiode est formée par une prise de substrat (non représentée) en contact avec le substrat SUB. D'autres structures de photodiodes peuvent bien entendu convenir.

La couche d'avalanche AZ s'étend de part et d'autre de la jonction PN, d'une profondeur minimum Pm atteinte par un photon ayant une longueur d'onde inférieure ou égale à une longueur d'onde minimum $\lambda m$, jusqu'à une profondeur maximum PM atteinte par un photon ayant une longueur d'onde supérieure ou égale à une longueur d'onde maximum $\lambda M$. La couche d'avalanche AZ apparaît donc à partir d'une profondeur Pm et s'étend sur une épaisseur PM-Pm correspondant à la plage de longueurs d'onde maximum [$\lambda m$, $\lambda M$] des photons à détecter. L'épaisseur de la couche AZ dépend de la tension de polarisation BV inverse de la photodiode.

Sur la figure 3A, un photon incident PH de longueur d'onde $\lambda 1$ (appartenant à [$\lambda m$, $\lambda M$]) crée dans la couche d'avalanche AZ à une profondeur P($\lambda 1$) une paire d'électron-trou qui génère par le phénomène d'avalanche des électrons libres dont le nombre dépend de l'écart entre les profondeurs P($\lambda 1$) et PM. Sur la figure 3B, un photon incident PH1 de longueur d'onde $\lambda 2$ (comprise entre $\lambda m$ et $\lambda 1$) pénètre dans la couche d'avalanche AZ à une profondeur P($\lambda 2$) comprise entre les profondeurs Pm et P($\lambda 1$). Il en résulte que le phénomène d'avalanche se propage dans une zone plus étendue (entre P($\lambda 2$) et PM) et donc que le nombre d'électrons libres générés par le photon PH1 est plus élevé que celui généré par le photon PH sur la figure 3A. Par conséquent, le photon PH1 génère une impulsion de courant PL2 d'amplitude supérieure à celle PL1 générée par le photon PH. Le nombre de charges collectées augmente donc lorsque la profondeur de pénétration du photon diminue et donc lorsque la longueur d'onde de ce dernier diminue. Ainsi, à la suite de la réception d'un photon, la photodiode PD génère un signal avec un gain qui augmente lorsque la longueur d'onde du photon incident diminue.

L'amplitude I de l'impulsion de courant PL1, PL2 générée par la photodiode PD suite à la réception d'un photon incident peut être modélisée par la formule théorique simplifiée suivante (qui ne tient pas compte d'éventuelles non linéarités) :

$$
\begin{cases}
I = k\,e(G+1) & \text{pour } P(\lambda) < Pm \\[2mm]
I = k\,e\left[\left(1 - \dfrac{P(\lambda) - Pm}{PM - Pm}\right)G + 1\right] & \text{pour } Pm < P(\lambda) < PM \\[2mm]
I = k\,e & \text{pour } P(\lambda) > PM
\end{cases} \qquad (1)
$$

dans laquelle e représente la charge électrique d'un électron, soit $1{,}602\ 10^{-19}$ C, $P(\lambda)$ est la profondeur de pénétration du photon dans la photodiode, variant en fonction de la longueur d'onde $\lambda$ de ce dernier, G est le gain maximum de la photodiode obtenu avec un photon générant une paire d'électron-trou au voisinage de la limite supérieure de la couche d'avalanche AZ ($P(\lambda)$ voisin de Pm), et k est un facteur dépendant du temps de réponse de la diode (dépend de la construction de la diode). Il en résulte qu'un photon ayant une longueur d'onde inférieure ou égale à la longueur d'onde minimum $\lambda$m génère aux bornes de la photodiode une impulsion de courant d'amplitude k·e(G+1), et qu'un photon ayant une longueur d'onde supérieure ou égale à la longueur d'onde maximum $\lambda$M génère une impulsion de courant d'amplitude égale à k·e. Le gain G peut atteindre un ou plusieurs milliers dans un substrat en silicium et un à plusieurs centaines dans un substrat en tellurure de cadmium et de mercure.

Les figures 4A et 4B représentent une courbe d'évolution de l'amplitude I d'une impulsion de courant générée un photon en fonction de la profondeur de pénétration $P(\lambda)$ du photon dans la photodiode PD, conformément à la formule (1). Cette courbe montre que dans la couche d'avalanche AZ (délimitée par les profondeurs Pm et PM), l'amplitude I diminue linéairement en fonction de la profondeur de pénétration du photon dans la photodiode. Cette propriété est exploitée dans un mode de réalisation pour discriminer les photons pénétrant dans la photodiode en fonction de leur longueur d'onde. Sur la figure 4A, le photon PH de longueur d'onde $\lambda$1 qui atteint une profondeur $P(\lambda1)$ dans la couche d'avalanche AZ, génère une impulsion de courant d'amplitude $I(P(\lambda1))$ comprise entre k·e et k·e(G+1). Sur la figure 4B, le photon PH1 de longueur d'onde $\lambda$2 qui atteint une profondeur $P(\lambda2)$ dans la couche d'avalanche AZ, génère une impulsion de courant d'amplitude $I(P(\lambda2))$ comprise entre $I(P(\lambda1))$ et k·e(G+1) puisque la profondeur $P(\lambda2)$ est inférieure à la profondeur $P(\lambda1)$.

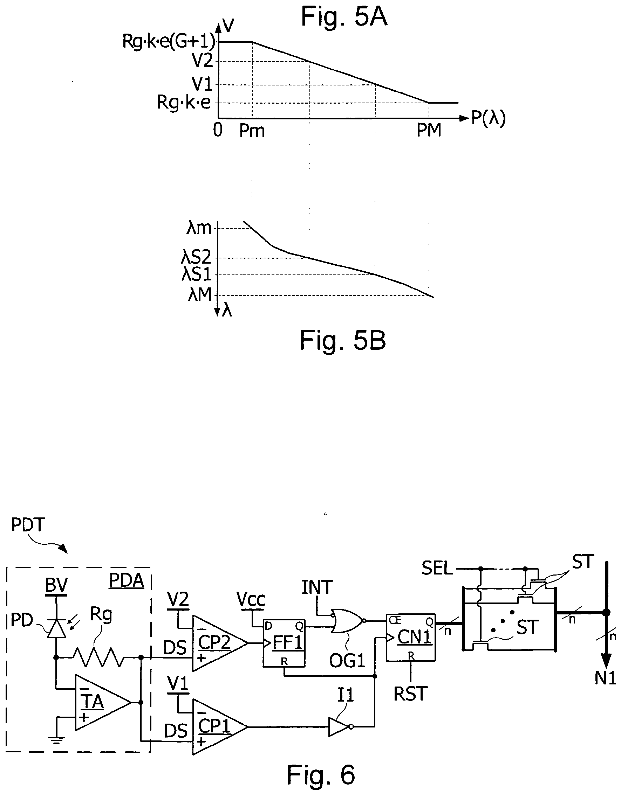

La figure 5 représente un circuit PDA permettant d'exploiter le signal fourni par la photodiode PD. Dans le circuit PDA, la photodiode PD est associée à un amplificateur à transimpédance ayant pour fonction de convertir les impulsions de courant P1, P2 produites par la photodiode en impulsions de tension. La photodiode PD reçoit sur sa cathode la tension de polarisation BV. L'anode de la photodiode est connectée à une entrée inverseuse d'un amplificateur différentiel TA monté en amplificateur différentiel à contre réaction. A cet effet, l'entrée directe de l'amplificateur TA est connectée à la masse, et la sortie de l'amplificateur TA est reliée par l'intermédiaire d'une résistance Rg à l'entrée inverseuse de l'amplificateur. L'amplificateur TA fournit un signal de sortie DS comportant une impulsion de tension à chaque fois que la photodiode PD fournit une impulsion de courant. Le circuit PDA présente un gain donné par la valeur de la résistance Rg et la tension V du signal DS peut être calculée de la manière suivante :

$$
V = Rg\ I \qquad\qquad\qquad\qquad (2)
$$

dans laquelle I est le courant traversant la photodiode PD.

La figure 5A représente une courbe de variation de l'amplitude d'une impulsion du signal DS générée lorsqu'un photon pénètre dans la photodiode PD, en fonction de la profondeur de pénétration P du photon dans la photodiode, conformément aux formules (1) et (2). La courbe de la figure 5A montre que dans la couche d'avalanche AZ (délimitée par les profondeurs Pm et PM), la tension d'une impulsion générée par un photon diminue en fonction de la profondeur de pénétration P du photon. Par ailleurs, un photon ayant une longueur d'onde inférieure ou égale à la longueur d'onde minimum $\lambda$m génère dans le signal DS une impulsion de tension d'amplitude Rg·k·e(G+1), et un photon ayant une longueur d'onde supérieure ou égale à la longueur d'onde maximum $\lambda$M génère une impulsion de tension d'amplitude égale à Rg·k·e. Il en résulte que le signal DS ne permet pas de discriminer des longueurs d'onde de photons inférieures à la longueur d'onde minimum $\lambda$m et supérieures à la longueur d'onde maximum $\lambda$M.

Par conséquent, si l'on souhaite détecter des photons dans une certaine plage de longueurs d'onde, la photodiode peut être choisie ou adaptée pour que tous les photons à détecter puissent atteindre la couche d'avalanche et sans aller au-delà, avec une tension de polarisation inverse acceptable pour la photodiode. En d'autres termes, la photodiode peut être configurée pour que sa couche d'avalanche puisse inclure une plage de profondeurs de pénétration dans la photodiode de photons à détecter, cette plage de profondeurs correspondant à la plage de longueurs d'onde de ces photons. A cet effet, l'épaisseur de la couche non dopée ou faiblement dopée INT (qui peut être omise) de la couche de collection CZ peut être telle que la limite supérieure de la couche d'avalanche puisse être atteinte par des photons ayant la plus petite longueur d'onde à détecter. De même, la limite inférieure de la couche d'avalanche peut être située à une profondeur supérieure à la profondeur atteinte par des photons ayant la plus grande longueur d'onde à détecter. Le positionnement de la limite inférieure de la couche d'avalanche est lié au choix du matériau semi-conducteur constituant la photodiode et à la profondeur de la jonction pn dans la photodiode. Le choix du matériau semi-conducteur constituant la photodiode détermine aussi les profondeurs de pénétration des photons en fonction de leur longueur d'onde dans le matériau. Ce choix influe donc sur la sélectivité en longueur d'onde de la photodiode qui peut être définie par le rapport entre un écart de profondeurs atteintes par des photons (sensiblement proportionnel à un écart de tensions mesurées), et un écart des longueurs d'onde de ces photons.

Il est à noter que la photodiode peut recevoir les photons non pas du côté de la couche dopée N+, mais du côté du substrat, N c'est-à-dire que les photons pénètrent dans la diode par le substrat avant d'atteindre la couche dopée P. Dans ce cas, l'amplitude du signal est inversée, la tension d'une impulsion générée par un photon augmentant avec la profondeur de pénétration P du photon, et donc avec la longueur d'onde de ce dernier.

La figure 5B représente une courbe de variation de la profondeur de pénétration d'un photon dans le matériau semi-conducteur constituant la photodiode PD, en fonction de la longueur d'onde du photon. Il est à noter que cette courbe dépend essentiellement de la nature du matériau semi-conducteur. La courbe de la figure 5B est placée en coïncidence avec la courbe de la figure 5A, de sorte que la combinaison de ces deux courbes montre qu'une longueur d'onde de photon dans la plage [λm, λM] correspond à une unique tension d'impulsion apparaissant dans le signal DS en sortie du circuit PDA, et réciproquement.

Le circuit PDA peut être associé à un circuit permettant de déterminer l'appartenance de la longueur d'onde d'un photon incident à une ou plusieurs plages de longueurs d'onde. Ainsi, la figure 6 représente un circuit PDT de génération de signaux représentatifs de l'éclairement de la photodiode dans une plage de longueurs d'onde, selon un mode de réalisation. Sur la figure 6, le signal DS est fournit à une entrée directe de deux comparateurs CP1, CP2 recevant chacun sur une entrée inverseuse une tension de seuil V1, V2 respective. La sortie du comparateur CP1 est reliée par l'intermédiaire d'un inverseur I1 à une entrée de signal d'horloge d'un compteur CN1. La sortie du comparateur CP2 est connectée à une entrée de signal d'horloge d'une bascule FF1 de type D comportant une sortie directe Q connectée à une entrée directe d'une porte logique OG1 de type NON OU. L'entrée D de la bascule FF1 reçoit la tension d'alimentation Vcc du circuit PDT. La sortie de l'inverseur I1 est également connectée à une entrée de commande d'initialisation de la bascule FF1. La sortie de porte OG1 est connectée à une entrée de comptage du compteur CN1. Un signal de commande d'intégration INT est fourni à une entrée inversée de la porte OG1. Un signal de commande d'initialisation RST est fourni à une entrée d'initialisation du compteur CN1. La sortie du compteur CN1 fournit une valeur numérique de comptage, par exemple sur 8 ou 16 bits, représentative du nombre d'impulsions détectées par le comparateur CP1, mais pas par le comparateur CP2.

Les tensions de seuil V1, V2 sont choisies de manière à correspondre à des longueurs d'onde de seuil λS1 et λS2 comprises entre les longueurs d'onde minimum λm et maximum λM. Sur les figures 5A et 5B, les tensions V1 et V2 délimitent ainsi une plage de longueurs d'onde [λS2, λS1] de photons auxquels la photodiode PD est sensible. Ainsi, le circuit PDT fournit une valeur numérique représentative du nombre de photons ayant une longueur d'onde située dans la plage de longueurs d'onde [λS2, λS1] ayant pénétré dans la photodiode PD. Il est à noter que la tension de seuil V1 peut être choisie égale à Rg·k·e de manière à correspondre à la longueur d'onde maximum λM des photons à détecter. La tension V1 peut également être ajustée de manière à s'affranchir du bruit.

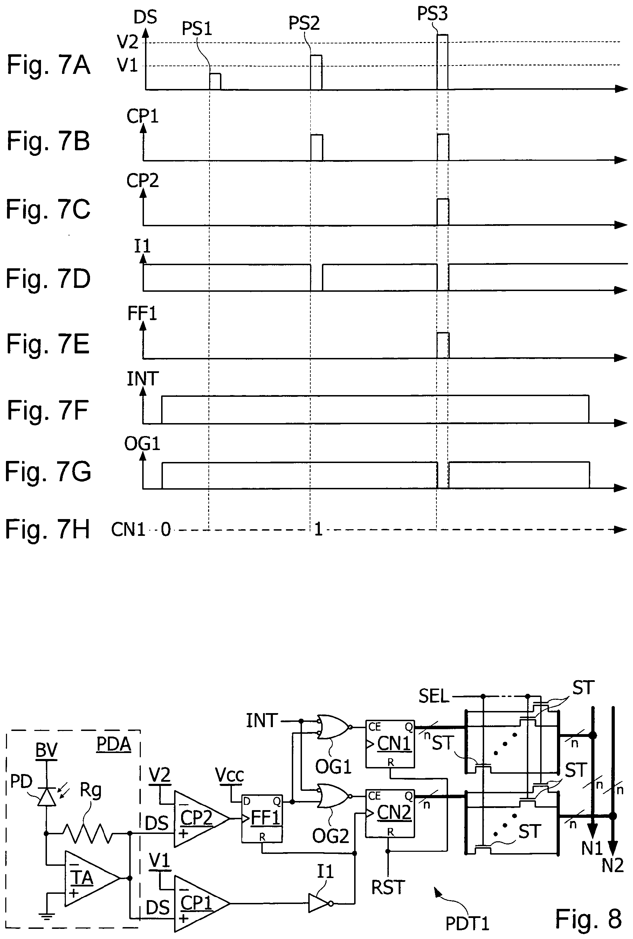

Les figures 7A à 7H illustrent le fonctionnement du circuit PDT. La figure 7A est un chronogramme du signal DS. Les figures 7B, 7C, 7D et 7E sont des chronogrammes des signaux de sortie des comparateurs CP1, CP2 de l'inverseur I1 et de bascule FF1. Les figures 7F et 7G sont des chronogrammes du signal INT et du signal de sortie de la porte OG1. La figure 7H indique l'évolution de la valeur du compteur CN1 en fonction du temps en correspondance avec les chronogrammes des figures 7A à 7G. Le chronogramme du signal DS (figure 7A) comprend une première impulsion PS1 dont l'amplitude est inférieure à la tension de seuil V1. Cette impulsion n'entraîne pas de changement d'état des sorties des comparateurs CP1 et CP2 qui restent à 0. La sortie de la bascule FF1 reste donc à 0, et la sortie de l'inverseur I1 reste à 1. Pendant une période d'acquisition du signal issu de la photodiode (signal INT à 1), la sortie de la porte OG1 est à 1. Le compteur CN1 n'est pas incrémenté et reste à 0 en l'absence d'impulsion de comptage fournie par l'inverseur I1. Il est à noter que tant que le signal INT est à 0, la sortie de la porte OG1 reste à 0. Le compteur CN1 ne peut donc pas être incrémenté.

Le chronogramme du signal DS comprend ensuite une seconde impulsion PS2 dont l'amplitude est supérieure à la tension de seuil V1, mais inférieure à la tension V2. La sortie du comparateur CP1 fournit une impulsion et la sortie du comparateur CP2 reste à 0. La sortie de l'inverseur I1 fournit donc également une impulsion inverse dont le front descendant déclenche une opération de comptage par le compteur CN1. Parallèlement, comme la sortie du comparateur CP2 est restée à 0, la bascule FF1 ne change pas d'état et la sortie de la porte OG1 reste à 1. Le compteur CN1 est donc incrémenté de un lors de l'opération de comptage. Le front montant du signal de sortie de l'inverseur I1 initialise ensuite l'état de la bascule FF1 qui reste à 0.

Le chronogramme du signal DS comprend ensuite une troisième impulsion PS3 dont l'amplitude est supérieure aux tensions de seuil V1 et V2. La sortie de chaque comparateur CP1, CP2 fournit donc une impulsion, et la sortie de l'inverseur I1 fournit également une impulsion inverse dont le front descendant déclenche une opération de comptage par le compteur CN1. L'impulsion en sortie du comparateur CP2 provoque un changement d'état de la bascule FF1. La sortie de la porte OG1 passe donc à 0 et ne déclenche pas d'incrémentation du compteur CN1 qui reste à 1 lors de l'opération de comptage. A la fin de l'impulsion PS3, le front montant du signal de sortie de l'inverseur I1 déclenche ensuite l'initialisation de la bascule FF1 qui repasse à 0, et le signal de sortie de la porte OG1 repasse à 1.

Il en résulte que le compteur CN1 est incrémenté de un à l'apparition d'une impulsion dans le signal DS seulement lorsque l'amplitude de cette impulsion est comprise entre les tensions V1 et V2, et pendant la période d'acquisition du signal de la photodiode (signal INT à 1). A la fin de chaque période d'acquisition, le compteur CN1 fournit donc une valeur représentative du nombre de photons ayant atteint la photodiode PD pendant la période d'acquisition et ayant une longueur d'onde comprise dans une plage de longueur d'onde délimitée par des longueurs d'onde de seuil λS1 et λS2 correspondant aux tensions de seuil V1 et V2. Lorsque le signal INT passe à 0, le compteur CN1 une fois lu, peut être initialisé à 0 à l'aide du signal RST, pour permettre une nouvelle acquisition du signal de la photodiode.

Si la photodiode PD constitue un pixel d'un capteur d'image comprenant une matrice de pixels, chaque bit de la sortie Q du compteur CN1 peut être relié à une ligne d'un bus parallèle de sortie N1 du capteur d'image par l'intermédiaire d'un transistor de sélection ST, par exemple de type CMOS à canal n. Tous les transistors ST reliés à un bit de sortie Q du compteur CN1 sont commandés par un même signal de sélection SEL du pixel. Lorsque les transistors ST sont rendus passants durant une impulsion fournie par le signal SEL, la valeur du compteur CN1 est transférée sur le bus N1. <

Il est à noter qu'en inversant le signal de sortie de la bascule FF1 avant de le fournir à la porte OG1, le circuit PDT peut permettre de compter les photons reçus par la photodiode PD et ayant une longueur d'onde inférieure à la longueur d'onde λS2. Les tensions V1 et V2 peuvent également être modifiées au cours du temps pour ajuster la plage de longueurs d'onde des photons à détecter. Ainsi, le circuit PDT peut être utilisé pour effectuer successivement et alternativement une détection de photons dans plusieurs plages de longueurs d'onde.

La figure 8 représente un circuit de génération PDT1 de signaux représentatifs de l'éclairement de la photodiode PD dans chacune de deux plages de longueurs d'onde, selon un mode de réalisation. Le circuit PDT1 diffère du circuit PDT en ce qu'il comprend deux portes logiques OG1, OG2 de type NON OU, et deux compteurs CN1, CN2. La sortie Q de la bascule FF1 est connectée à une entrée inversée de la porte OG1 et à une entrée directe de la porte OG2. Le signal INT est fourni à une entrée inversée des portes OG1 et OG2. La sortie de la porte OG1 est connectée à une entrée de comptage du compteur CN1 et la sortie de la porte OG2 est connectée à une entrée de comptage du compteur CN2. Le signal d'initialisation RST est connecté à une entrée de commande d'initialisation des compteurs CN1, CN2.

De cette manière, les impulsions du signal DS fournies par le circuit PDA à la suite de la réception d'un photon par la photodiode PD sont comparées aux tensions de seuil V1 et V2. Les impulsions supérieures à la tension de seuil V1 et inférieures à la tension de seuil V2 incrémentent le compteur CN1 et les impulsions supérieures à la tension de seuil V2 incrémentent le compteur CN2.

Si la photodiode PD constitue un pixel d'un capteur d'image comprenant une matrice de pixels, les bits de la sortie Q de chaque compteur CN1, CN2 peuvent être reliés à une ligne respective d'un bus parallèle de sortie N1, N2 du capteur d'image, par l'intermédiaire de transistors de sélection ST dont la grille est commandée par un unique signal de sélection de pixel SEL. Ainsi, en mettant le signal SEL dans son état actif, les valeurs des compteurs CN1, CN2 peuvent être transférées sur les bus N1, N2. A la suite de la lecture des valeurs des compteurs CN1, CN2, les compteurs peuvent être remis à 0 par une impulsion fournie par le signal d'initialisation RST.

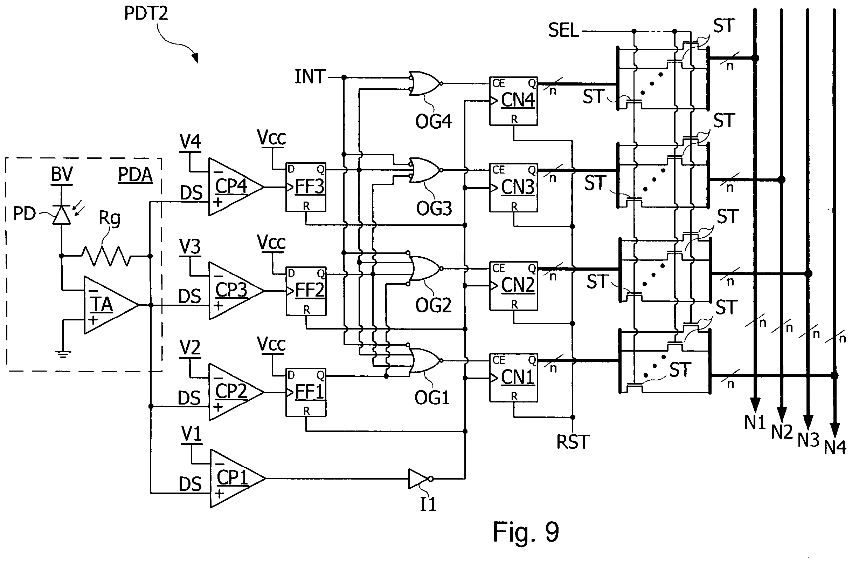

La figure 9 représente un circuit de génération PDT2 de signaux représentatifs de l'éclairement de la photodiode dans quatre plages de longueurs d'onde, selon un mode de réalisation. Le circuit PDT2 diffère du circuit PDT en ce qu'il comprend deux comparateurs supplémentaires CP3, CP4 pour comparer le signal DS à deux tensions de seuil supplémentaires V3, V4, telles que V1 < V2 < V3 < V4. La tension V3 délimite avec la tension V2 une seconde plage de longueurs d'onde et avec la tension V4 une troisième plage de longueurs d'onde. La tension V4 délimite une quatrième plage de longueurs d'onde située au delà de la longueur d'onde correspondant à cette tension. Le circuit PDT2 comprend également deux bascules de type D FF2, FF3 supplémentaires, trois portes logiques OG2, OG3, OG4 supplémentaires, et trois compteurs CN2, CN3, CN4 supplémentaires. La sortie de l'inverseur I1 est connectée à une entrée de signal d'horloge des compteurs CN1 à CN4. Le signal d'intégration INT est fourni à une entrée inversée de chacune des portes OG1 à OG4. L'entrée D des bascules FF1 à FF3 reçoit la tension d'alimentation Vcc du circuit PDT2. La sortie Q de la bascule FF1 est connectée à une entrée directe de la porte OG1 et à une entrée inversée de la porte OG2. La sortie du comparateur CP3 est connectée à une entrée de signal d'horloge de la bascule FF2. La sortie Q de la bascule FF2 est connectée à une entrée directe des portes OG1 et OG2 et à une entrée inversée de la porte OG3. La sortie du comparateur CP4 est connectée à une entrée de signal d'horloge de la bascule FF3. La sortie Q de la bascule FF3 est connectée à une entrée directe des portes OG1, OG2 et OG3 et à une entrée inversée de la porte OG4. La sortie de chaque porte OG1 à OG4 est connectée à une entrée de comptage d'un des compteurs CN1 à CN4.

De cette manière, le compteur CN1 est incrémenté de un pendant une période d'acquisition (signal INT à 1) lorsque la photodiode PD reçoit un photon dont la longueur d'onde est comprise entre deux longueurs d'onde correspondant respectivement aux tensions V1 et V2. Le compteur CN2 est incrémenté de un pendant la période d'acquisition lorsque la photodiode PD reçoit un photon dont la longueur d'onde est comprise entre deux longueurs d'onde correspondant respectivement aux tensions V2 et V3. Le compteur CN3 est incrémenté de un pendant la période d'acquisition lorsque la photodiode PD reçoit un photon dont la longueur d'onde est comprise entre deux longueurs d'onde correspondant respectivement aux tensions V3 et V4. Le compteur CN4 est incrémenté de un pendant la période d'acquisition lorsque la photodiode PD reçoit un photon dont la longueur d'onde est inférieure à la longueur d'onde correspondant à la tension V4. Il est à noter que s'il n'est pas souhaité détecter des photons dont la longueur d'onde est inférieure à la longueur d'onde correspondant à la tension V4, la porte OG4 et le compteur CN4 peuvent être omis.

Si la photodiode PD constitue un pixel d'un capteur d'image comprenant une matrice de pixels, chaque bit de la sortie Q de chaque compteur CN1 à CN4 peut être relié à une ligne d'un bus de sortie N1, N2, N3, N4 du capteur d'image par l'intermédiaire d'un transistor de sélection ST. Tous les transistors ST reliés à un bit de sortie Q d'un des compteurs CN1 à CN4 sont commandés par un même signal de sélection de pixel SEL. Ainsi, en mettant le signal SEL dans son état actif, les valeurs des compteurs CN1 à CN4 peuvent être transférées sur les bus N1 à N4. A la suite de la lecture des valeurs des compteurs CN1 à CN4, les compteurs peuvent être remis à 0 par une impulsion fournie par le signal d'initialisation RST.

Le circuit PDT2 permet ainsi avec une unique photodiode de fournir plusieurs signaux représentatifs de la réception par une unique photodiode de photons respectivement dans plusieurs plages de longueurs d'onde.

Il est à noter que davantage de plages de longueurs d'onde peuvent être ainsi discriminées moyennant la prévision d'autres comparateurs pour comparer le signal DS à d'autres tensions de seuil correspondant à d'autres limites de plages de longueur d'onde. Il peut être également prévu que les plages de longueurs d'onde discriminées par les comparateurs se recouvrent partiellement, en ajustant les tensions de seuil V1 à V4 de manière à former des plages de tension qui se chevauchent partiellement. Il peut aussi être prévu de rejeter une ou plusieurs plages de longueurs d'onde, par exemple en supprimant l'une des portes OG1 à OG4 et le compteur CN1 à CN4 connecté à la porte supprimée, de manière ne pas effectuer de comptage d'impulsion de sortie de l'amplificateur TA lorsque l'amplitude de cette impulsion est comprise entre deux des tensions V1 à V4.

Il apparaîtra clairement à l'homme de l'art que la présente invention est susceptible de diverses variantes de réalisation et diverses applications. En particulier, l'invention n'est pas limitée à l'usage d'une photodiode ne présentant pas de couche de collection. Il importe simplement que la couche d'avalanche de la photodiode puisse être compatible avec la plage de longueurs d'onde de photons à détecter. Dès lors que cette condition peut être réalisée, la présente invention peut s'appliquer à toutes les bandes de longueurs d'onde.

Les circuits des figures 6, 8 et 9 effectuent une conversion des impulsions de courant issues de la photodiode en impulsions de tension et une comparaison des impulsions de tension avec des seuils de tension. Ces circuits peuvent peut bien entendu être aisément modifiés pour amplifier les impulsions de courant et comparer ces impulsions de courant amplifiées à des seuils de courant.

Grâce à sa capacité à discriminer des bandes de longueurs d'onde étroites, le dispositif de détection qui vient d'être décrit peut être avantageusement utilisé dans de nombreuses applications. Ainsi, en astronomie, le dispositif de détection peut fournir des images simultanément dans différentes bandes spectrales. Au contraire, les dispositifs actuels ne peuvent effectuer de telles observations dans différentes bandes spectrales que séquentiellement. Le dispositif de détection peut également s'appliquer à la vision hyperspectrale. En effet, le dispositif de détection s'avère particulièrement adapté à la vision simultanée dans plusieurs bandes étroites et contiguës. Le dispositif de détection peut aussi assurer la fonction de pré disperseur dans un spectroscope à dispersion croisée pour trier les ordres d'un réseau ou d'un interféromètre. Dans le domaine biomédical et en particulier en imagerie par fluorescence et par bioluminescence, le dispositif peut discriminer les photons d'excitation, les photons fluorescents, et les marqueurs bioluminescents, dès lors que ceux-ci présentent des longueurs d'onde différentes. Le dispositif de détection peut également être utilisé dans le domaine infrarouge pour déterminer la température absolue d'un corps observé, en détectant des photons simultanément deux ou plusieurs bandes spectrales. Le dispositif de détection également particulièrement adapté aux communications DWDM (Dense Wavelength Division Multiplexing) consistant à transmettre dans une fibre optique plusieurs communications laser à des longueurs d'onde différentes. Le dispositif de détection peut également être utilisé en physique des particules pour déterminer l'énergie (c'est-à-dire la longueur d'onde) de photons.

Par ailleurs, la simplicité et donc la rapidité des circuits logiques de traitement des signaux détectés rend le dispositif de détection particulièrement adapté à la détermination avec une grande précision du temps de vol d'un photon dans un système de LADAR (radar laser) lorsque la détection est synchronisée avec un laser pulsé, ou dans un système de tomographie par émission de positons.

**Revendications**

1. Procédé de détection de photons, comprenant une étape de soumission d'une photodiode formée dans un matériau semi-conducteur, à une tension de polarisation (BV) telle qu'un phénomène d'avalanche soit déclenché dans une couche d'avalanche (AZ) de la photodiode lorsqu'un photon (PH, PH1) pénètre dans la photodiode, **caractérisé en ce que** la couche d'avalanche (AZ) s'étend dans le matériau semi-conducteur d'une profondeur minimum (Pm) à une profondeur maximum (PM) de manière à pouvoir être atteinte par des photons (PH, PH1) ayant une longueur d'onde comprise entre des longueurs d'onde minimum et maximum ($\lambda$m, $\lambda$M), le procédé comprenant des étapes de comparaison de l'amplitude d'un signal (DS) fourni par la photodiode à deux valeurs de seuil (V1, V2) distinctes, et de déduction que la photodiode a reçu un photon ayant une longueur d'onde comprise entre deux longueurs d'onde de seuil ($\lambda$S1, $\lambda$S2) comprises entre les longueurs d'onde minimum et maximum, si l'amplitude du signal est comprise entre les deux valeurs de seuil.

2. Procédé selon la revendication 1, comprenant des étapes de comptage pendant une période d'acquisition, d'un nombre d'impulsions détectées aux bornes de la photodiode (PD), ayant une amplitude comprise entre les deux valeurs de seuil (V1, V2) pour obtenir une valeur représentative d'un nombre de photons (PH, PH1) ayant pénétré dans la photodiode (PD) pendant la période d'acquisition, et ayant une longueur d'onde comprise entre les deux longueurs d'onde de seuil ($\lambda$S1, $\lambda$S2).

3. Procédé selon la revendication 1 ou 2, comprenant des étapes de comptage pendant une période d'acquisition, d'un nombre d'impulsions détectées aux bornes de la photodiode (PD), ayant une amplitude supérieure à la plus grande des deux valeur de seuil (V2) pour obtenir une valeur représentative d'un nombre de photons (PH, PH1) ayant pénétré dans la photodiode (PD) pendant la période d'acquisition, et ayant une longueur d'onde inférieure à la plus petite des deux longueurs d'onde de seuil ($\lambda$S2).

4. Procédé selon l'une des revendications 1 à 3, dans lequel la plus petite des deux valeurs de seuil (V1) correspond à une longueur d'onde extrême ($\lambda$S1) de photon à détecter.

5. Procédé selon l'une des revendications 1 à 4, comprenant des étapes de comparaison de l'amplitude du signal (DS) fourni par la photodiode à plusieurs autres valeurs de seuil (V3, V4), de manière à délimiter avec les deux valeurs de seuil (V1, V2) plusieurs plages de valeurs d'amplitude, et de comptage pendant une période d'acquisition de nombres d'impulsions du signal (DS) dans chacune des plages de valeurs d'amplitude.

6. Procédé selon la revendication 5, dans lequel des plages de valeurs d'amplitude d'impulsion délimitées par les valeurs de seuil (V1, V2, V3, V4) sont non contiguës et/ou se chevauchent.

7. Procédé selon l'une des revendications 1 à 6, comprenant une étape d'ajustement des valeurs de seuil pour ajuster des plages de longueurs d'onde dans lesquelles des photons sont à détecter.

8. Procédé selon l'une des revendications 1 à 7, comprenant une étape d'ajustement de la tension de polarisation de la photodiode pour que tous les photons à détecter puissent atteindre la couche d'avalanche et sans aller au-delà.

9. Dispositif de détection de photons, comprenant une photodiode formée dans un matériau semi-conducteur, et soumise à une tension de polarisation (BV) telle qu'un phénomène d'avalanche soit déclenché dans une couche d'avalanche (AZ) de la photodiode lorsqu'un photon (PH, PH1) pénètre dans la photodiode, **caractérisé en ce que** la couche d'avalanche (AZ) s'étend dans le matériau semi-conducteur d'une profondeur minimum (Pm) à une profondeur maximum (PM) de manière à pouvoir être atteinte par des photons (PH, PH1) ayant une longueur d'onde comprise entre des longueurs d'onde minimum et maximum ($\lambda$M, $\lambda$M), le dispositif étant configuré pour :

   comparer l'amplitude d'un signal (DS) fourni par la photodiode à deux valeurs de seuil (V1, V2) distinctes, et déterminer que la photodiode a reçu un photon ayant une longueur d'onde comprise entre deux longueurs d'onde de seuil ($\lambda$S1, $\lambda$S2) comprises entre les longueurs d'onde minimum et maximum, si l'amplitude du signal est comprise entre les deux valeurs de seuil.

10. Dispositif selon la revendication 9, configuré pour mettre en oeuvre le procédé selon l'une des revendications 2 à 8.

11. Dispositif selon la revendication 9 ou 10, dans lequel la photodiode (PD) comprend une couche de collection (CZ) de faible dopage ou non dopée dont l'épaisseur est réduite de manière à ce que la couche d'avalanche (AZ) puisse s'étendre au moins jusqu'à une profondeur atteinte par des photons ayant une longueur d'onde extrême à détecter.

12. Dispositif selon l'une des revendications 9 à 11, dans lequel la photodiode (PD) comprend une jonction pn réalisée à une certaine profondeur dans le matériau semi-conducteur, le matériau semi-conducteur et la profondeur de la jonction pn étant choisis de manière à ce que le matériau semi-conducteur puisse être traversé par des photons à détecter jusqu'à une profondeur susceptible d'être située dans la couche d'avalanche (AZ) de la photodiode.

13. Imageur, comprenant plusieurs dispositifs de détection selon l'une des revendications 9 à 12, les photodiodes (PD) des dispositifs de détection étant disposées selon une configuration matricielle.


**Patentansprüche**

1. Verfahren zur Photonendetektion, das einen Ablaufschritt umfasst, eine Fotodiode, die in einem Halbleitermaterial ausgebildet ist, einer Polarisierungsspannung (BV) zu unterwerfen, so dass ein Lawinenphänomen in einer Lawinenschicht (AZ) der Fotodiode ausgelöst wird, wenn ein Photon (PH, PH1) in die Fotodiode eindringt, **dadurch gekennzeichnet, dass** die Lawinenschicht (AZ) sich in dem Halbleitermaterial von einer minimalen Tiefe (Pm) zu einer maximalen Tiefe (PM) erstreckt, so dass sie von den Photonen (PH, PH1) erreicht werden kann, die eine Wellenlänge aufweisen, die zwischen der minimalen und der maximalen Wellenlänge (Am, AM) liegt, wobei das Verfahren die Ablaufschritte umfasst: Vergleich der Amplitude des Signals (DS), das von der Fotodiode bereitgestellt wird, bei zwei verschiedenen Schwellenwerten (V1, V2), und die Herleitung, dass die Fotodiode ein Photon empfangen hat, das eine Wellenlänge aufweist, die zwischen zwei Grenzwellenlängen (AS1, λS2) liegt, die zwischen der minimalen und der maximalen Wellenlänge liegen, falls die Signalamplitude zwischen den zwei Schwellenwerten liegt.

2. Verfahren nach Anspruch 1, das die Ablaufschritte der Zählung einer Anzahl von Impulsen während einer Erfassungsperiode umfasst, die an den Polklemmen der Fotodiode (PD) erfasst wurden, die eine Amplitude aufweisen, die zwischen den zwei Schwellenwerten (V1, V2) liegt, um einen repräsentativen Wert einer Anzahl von Photonen (PH, PH1) zu erlangen, die während der Erfassungsperiode in die Fotodiode (PD) eingedrungen sind, und die eine Wellenlänge aufweisen, die zwischen den beiden Grenzwellenlängen (λS1, λS2) liegt.

3. Verfahren nach Anspruch 1 oder 2, das die Ablaufschritte der Zählung einer Anzahl von Impulsen während einer Erfassungsperiode umfasst, die an den Polklemmen der Fotodiode (PD) erfasst wurden, die eine höhere Amplitude als der größere der zwei Schwellenwerte (V2) aufweisen, um einen repräsentativen Wert einer Anzahl von Photonen (PH, PH1) zu erlange, die während der Erfassungsperiode in die Fotodiode (PD) eingedrungen sind, und die die eine untere Wellenlänge aufweisen, die niedriger als die kleinere der zwei Grenzwellenlängen (λS2) ist.

4. Verfahren nach einem der Ansprüche 1 bis 3, in dem der kleinere der zwei Schwellenwerte (V1) einer äußersten Wellenlänge (λS1) des zu erfassenden Photons entspricht.

5. Verfahren nach einem der Ansprüche 1 bis 4, das die Ablaufschritte umfasst: Vergleich der Amplitude eines Signals (DS), das von der Fotodiode bei mehreren anderen Schwellenwerten (V3, V4) bereitgestellt wird, um mit den zwei Schwellenwerten (V1, V2) mehrere Wertebereiche der Amplitude einzugrenzen, und Zählung der Anzahl von Impulsen des Signals (DS) in jedem der Wertebereiche der Amplitude während einer Erfassungsperiode.

6. Verfahren nach Anspruch 5, in dem die Wertbereiche der Amplitude, die von den Schwellenwerten (V1, V2, V3, V4) eingegrenzt werden, nicht aneinander angrenzend sind und/oder sich nicht überlappen.

7. Verfahren nach einem der Ansprüche 1 bis 6, das einen Ablaufschritt der Anpassung der Schwellenwerte umfasst, um die Bereiche der Wellenlänge anzupassen, in denen die Photonen zu erfassen sind.

8. Verfahren nach einem der Ansprüche 1 bis 7, das einen Ablaufschritt der Anpassung der Polarisierungsspannung der Fotodiode umfasst, damit alle zu erfassenden Photonen die Lawinenschicht erreichen können und ohne darüber hinaus zu gehen.

9. Vorrichtung zur Photonendetektion, die eine Fotodiode umfasst, die in einem Halbleitermaterial ausgebildet ist und einer Polarisierungsspannung (BV) unterworfen ist, so dass ein Lawinenphänomen in einer Lawinenschicht (AZ) der Fotodiode ausgelöst wird, wenn ein Photon (PH, PH1) in die Fotodiode eindringt,
**dadurch gekennzeichnet, dass** die Lawinenschicht (AZ) sich in dem Halbleitermaterial von einer minimalen Tiefe (Pm) zu einer maximalen Tiefe (PM) erstreckt, so dass sie von den Photonen (PH, PH1) erreicht werden kann, die eine Wellenlänge aufweisen, die zwischen der minimalen und der maximalen Wellenlänge (Am, AM) liegt, wobei die Vorrichtung ausgestaltet ist für:

Vergleichen der Amplitude eines Signals (DS), das von der Fotodiode bereitgestellt wird, bei zwei verschiedenen Schwellenwerten (V1, V2), und
Bestimmen, dass die Fotodiode ein Photon empfangen hat, das eine Wellenlänge aufweist, die zwischen zwei Grenzwellenlängen ($\lambda$S1, $\lambda$S2) liegt, die zwischen der minimalen und der maximalen Wellenlänge liegen, falls die Signalamplitude zwischen den zwei Schwellenwerten liegt.

10. Vorrichtung nach Anspruch 9, die dazu ausgestaltet ist, das Verfahren nach einem der Ansprüche 2 bis 8 umzusetzen.

11. Vorrichtung nach Anspruch 9 oder 10, in der die Fotodiode (PD) eine Sammelschicht (CZ) von niedriger Dotierung oder nicht dotiert umfasst, deren Dicke reduziert ist, so dass die Lawinenschicht (AZ) sich mindestens bis in eine Tiefe erstrecken kann, die von den Photonen mit einer äußersten zu erfassenden Wellenlänge erreicht wird.

12. Vorrichtung nach einem der Ansprüche 9 bis 11, in der die Fotodiode (PD) eine Sperrschicht pn umfasst, die in einer bestimmten Tiefe in dem Halbleitermaterial realisiert ist, wobei das Halbleitermaterial und die Tiefe der Sperrschicht so gewählt sind, dass das Halbleitermaterial von den zu erfassenden Photonen bis zu einer Tiefe durchquert werden kann, die geeignet ist, in der Lawinenschicht (AZ) der Fotodiode zu liegen.

13. Bildgebungsvorrichtung, die mehrere Detektionsvorrichtungen nach einem der Ansprüche 9 bis 12 umfasst, wobei die Fotodioden (PD) der Detektionsvorrichtungen in einer Matrixkonfiguration angeordnet sind.

**Claims**

1. Method for detecting photons, comprising a step of subjecting a photodiode, made of a semiconductor material, to a polarization voltage (BV) in such a way that an avalanche phenomenon is triggered in an avalanche layer (AZ) of the photodiode when a photon (PH, PH1) penetrates the photodiode,
**characterized in that** the avalanche layer (AZ) extends in the semiconductor material from a minimum depth (Pm) to a maximum depth (PM) such that it can be reached by the photons (PH, PH1) that have a wavelength that is between the minimum and maximum wavelengths ($\lambda$m, $\lambda$M), the method comprising the steps of comparing the amplitude of a signal (DS) provided by the photodiode with two separate threshold values (V1, V2), and of deducing that the photodiode has received a photon having a wavelength that is between two threshold wavelengths ($\lambda$S1, $\lambda$S2) that are between the minimum and maximum wavelengths if the amplitude of the signal is between the two threshold values.

2. Method according to claim 1, comprising the steps of counting, during an acquisition period, a number of pulses detected at the terminals of the photodiode (PD) that have an amplitude that is between the two threshold values (V1, V2) in order to obtain a value that is representative of a number of photons (PH, PH1) that have penetrated the photodiode (PD) during the acquisition period and have a wavelength that is between the two threshold wavelengths ($\lambda$S1, $\lambda$S2).

3. Method according to either claim 1 or claim 2, comprising the steps of counting, during an acquisition period, a number of pulses detected at the terminals of the photodiode (PD) that have an amplitude that is greater than the larger of the two threshold values (V2) in order to obtain a value that is representative of a number of photons (PH, PH1) that have penetrated the photodiode (PD) during the acquisition period and have a wavelength that is smaller than the smaller of the two threshold wavelengths ($\lambda$S2).

4. Method according to any of claims 1 to 3, wherein the smaller of the two threshold values (V1) corresponds to an extreme wavelength ($\lambda$S1) of the photon to be detected.

5. Method according to any of claims 1 to 4, comprising the steps of comparing the amplitude of the signal (DS) provided by the photodiode with a plurality of other threshold values (V3, V4) so as to define, by means of the two threshold values (V1, V2), a plurality of amplitude value ranges, and of counting, during an acquisition period, numbers of pulses of the signal (DS) in each of the amplitude value ranges.

6.  Method according to claim 5, wherein the pulse amplitude value ranges defined by the threshold values (V1, V2, V3, V4) are not contiguous and/or overlap.

7.  Method according to any of claims 1 to 6, comprising a step of adjusting the threshold values in order to adjust the wavelength ranges in which the photons are to be detected.

8.  Method according to any of claims 1 to 7, comprising a step of adjusting the polarization voltage of the photodiode so that all the photons to be detected can reach the avalanche layer but without passing therebeyond.

9.  Device for detecting photons, comprising a photodiode that is made of a semiconductor material and is subjected to a polarization voltage (BV) in such a way that an avalanche phenomenon is triggered in an avalanche layer (AZ) of the photodiode when a photon (PH, PH1) penetrates the photodiode,
    **characterized in that** the avalanche layer (AZ) extends in the semiconductor material from a minimum depth (Pm) to a maximum depth (PM) such that it can be reached by the photons (PH, PH1) that have a wavelength that is between the minimum and maximum wavelengths ($\lambda$m, $\lambda$M), the device being designed to:

    compare the amplitude of a signal (DS) provided by the photodiode with two separate threshold values (V1, V2), and
    determine that the photodiode has received a photon that has a wavelength that is between two threshold wavelengths ($\lambda$S1, $\lambda$S2) that are between the minimum and maximum wavelengths if the amplitude of the signal is between the two threshold values.

10. Device according to claim 9 that is designed to implement the method according to any of claims 2 to 8.

11. Device according to either claim 9 or claim 10, wherein the photodiode (PD) comprises a weakly doped or undoped collection layer (CZ), the thickness of which is reduced such that the avalanche layer (AZ) can extend at least as far as a depth reached by the photons to be detected that have an extreme wavelength.

12. Device according to any of claims 9 to 11, wherein the photodiode (PD) comprises a p-n junction formed at a particular depth in the semiconductor material, the semiconductor material and the depth of the p-n junction being selected such that the photons to be detected can pass through the semiconductor material up to a depth that can be located in the avalanche layer (AZ) of the photodiode.

13. Imager comprising a plurality of detection devices according to any of claims 9 to 12, the photodiodes (PD) of the detection devices being arranged in a matrix configuration.

Fig. 1

Fig. 2A

Fig. 2B

Fig. 4A

Fig. 3A

Fig. 4B

Fig. 3B

Fig. 5

## Fig. 5A

## Fig. 5B

## Fig. 6

Fig. 7A

Fig. 7B

Fig. 7C

Fig. 7D

Fig. 7E

Fig. 7F

Fig. 7G

Fig. 7H

Fig. 8

Fig. 9

EP 2 652 792 B1

**EP 2 652 792 B1**

**RÉFÉRENCES CITÉES DANS LA DESCRIPTION**

**Documents brevets cités dans la description**

- US 20060131480 A

- US 5965875 A